(19) Europäisches Patentamt
European Patent Office
Office européen des brevets

(11) EP 4 391 383 A1

(12) EUROPEAN PATENT APPLICATION

(43) Date of publication:
26.06.2024 Bulletin 2024/26

(51) International Patent Classification (IPC):
*H03K 17/97* (2006.01)

(21) Application number: 22472006.0

(22) Date of filing: 23.12.2022

(52) Cooperative Patent Classification (CPC):
H03K 17/97; H03K 17/9512; H03K 17/9517

(84) Designated Contracting States:
AL AT BE BG CH CY CZ DE DK EE ES FI FR GB GR HR HU IE IS IT LI LT LU LV MC ME MK MT NL NO PL PT RO RS SE SI SK SM TR
Designated Extension States:
BA
Designated Validation States:
KH MA MD TN

(71) Applicant: Melexis Bulgaria EOOD
1138 Sofia (BG)

(72) Inventors:
• Georgiev Gaydov, Stoyan
1138 Sofia (BG)
• Tombez, Lionel
2022 Bevaix (CH)
• Angelov Hristov, Hristo
1138 Sofia (BG)

(74) Representative: Winger
Mouterij 16 bus 101
3190 Boortmeerbeek (BE)

(54) MAGNETIC SWITCH AND PROXIMITY SENSING

(57) A magnetic switch is provided, comprising a magnetic field sensing system configured for providing a first signal representative of the absolute value of a first component of the magnetic field in a first direction and at least a second signal representative of the absolute value of a second component of the magnetic field in a further direction different from the first direction. It includes comparing means adapted for comparing the sum of the absolute values of at least the first and second signals with a threshold value. The magnetic sensor further comprises a connection to the comparing means for providing at least one status signal as output of the switch.

FIG. 1

**Description**

**Field of the invention**

The invention relates to the field of magnetic field sensing. More specifically it relates to a magnetic switch and uses thereof in proximity sensing.

**Background of the invention**

Several applications require the use of magnetic field sensors, which use magnetic field sensing elements. These applications include current sensors that senses a magnetic field generated by a current through a conductor, position sensors for detecting position of a magnetic source, for example a rotation detector that senses passing of a magnetic sensitive materials such as gear teeth and the like.

In particular, magnetic switches are a type of position sensors that can be used to detect the presence or proximity of a magnetic object. Magnetic switches provide an output that is, in general, binary, indicating either the presence or the absence of the magnetic object. A threshold is defined, and the detected field is compared to the threshold, so that the switch provides a response or output depending on the result of the comparison.

Usually, magnetic switches detect the magnetic field in one direction using sensing elements. This means that the rest of components of the field may not be detected. Careful alignment is required, otherwise if the field is misaligned, switching may not be triggered even if the field is large enough to do so, since the switching only detects a reduced signal due to the misalignment. This introduces uncertainty in the switching. It may result in malfunctions.

Existing solutions include magnetic sensing in multiple directions, but these are either too simple and improve the sensitivity of the switch only slightly, or they require complex vectorial calculations and/or extensive memory usage to obtain an accurate threshold comparison with the actual magnetic field.

It would be desirable to provide accurate magnetic switching with a simple implementation.

**Summary of the invention**

It is an object of embodiments of the present invention to provide a magnetic switch for detecting magnetic field in two or three directions with a simple processing, good resolution and accurate approximation.

In a first aspect, a magnetic switch is provided, comprising a magnetic field sensing system configured for providing a first signal representative of the absolute value of a first component of the magnetic field in a first direction and at least a second signal representative of the absolute value of a second component of the magnetic field in a further direction different from the first direction, further comprising comparing means adapted for comparing the sum of the absolute values of at least the first and second signals with a threshold value. The magnetic sensor further comprises a connection to the comparing means for providing at least one status signal as output of the switch.

It is an advantage of embodiments of the present invention that the magnetic sensor can be used as a proximity sensor or the like, with simple circuitry.

In embodiments of the present invention, the sensing system comprises signal processing means for providing the absolute value of at least the first and second signals.

It is an advantage of embodiments of the present invention that the computation of the absolute value can be done easily, for example with an analog circuit such a as a multiplier, rectifier, amplifier, etc., or even digitally.

In embodiments of the present invention, the at least first direction and second direction are perpendicular to each other.

In some embodiments of the present invention, the sensing system comprises at least a sensing element configured to provide signals representative of the absolute values of the magnetic components in at least two different directions, e.g. perpendicular directions.

It is an advantage of embodiments of the present invention that sensing elements, such as magneto-resistors, can be easily implemented and their signal directly processed for comparison without need of further processing to obtain the absolute value.

In embodiments of the present invention, the switch further comprises an analog-to-digital converter for converting the analog signals in digital signals.

It is an advantage of embodiments of the present invention that signals can be easily transmitted, stored in registers and the like.

In some embodiments, the comparing means comprises a look-up table for comparing the values with stored values and determine whether there is switching or not.

In embodiments of the present invention, the switch is adapted for providing the first and at least the second signals sequentially.

It is an advantage of embodiments of the present invention that an accurate sensor with low power and energy consumption can be provided. It is an additional advantage that a single channel can be used to transmit both signals.

In embodiments of the present invention, the magnetic field sensing system comprises at least one sensing element adapted to provide the first signal and at least a further element adapted to provide the at least second signal. It is an advantage that an implementation can be provided with simple signal measurement.

In embodiments of the present invention, the switch is configured to provide one of a first or a second output value different from the first, wherein the first output value is provided if the sum is higher than a threshold value being a first threshold value, and wherein the second output value is provided if the sum is lower than a second threshold value, and wherein the switch is configured to switch from the first output value to the second output value, so that the switching from the first to the second output value occurs when the sum switches from being higher than the second threshold value to being lower, and the switching from the second to the first output value occurs when the sum switches from being lower than the first threshold value to being higher, wherein the second threshold value is lower than the first threshold value. It is an advantage that oscillating output signal can be avoided. In some embodiments, these thresholds are operation and release thresholds.

In embodiments of the present invention, the switch is configured to perform a further comparison if the switch provides a first output value and the sum is not below the threshold value, or if the switch provides a second output value and the sum is not over the threshold value, wherein the further comparison comprises comparing any of the absolute values of the at least first and signals with an additional threshold value above, respectively below, the threshold value, the switch being configured to subsequently switch the output value if any of the absolute values of the at least first and second signals sinks below, respectively surpasses, the additional threshold value.

This embodiment can be combined in embodiments where a first threshold is used if the switch is in a particular output and a second threshold is used if the switch is in a different output (in case of operational and release thresholds, for instance). In such embodiments, the switch is configured to perform a further comparison if the sum is higher than the second threshold value but lower than the first threshold value, wherein the second comparison comprises comparing each signal representative of the absolute value of each component to a third threshold value and/or a fourth threshold value, wherein the first output value is provided if any of the signals is higher than the third threshold value, so that the switching from the second to the first output value occurs when any of the signals surpasses the third threshold value, and/or wherein the second output value is provided if any of the signals is lower than the fourth threshold value, so that the switching from the first to the second output value occurs when any of the signals sinks below the fourth threshold value.

It is an advantage that the spatial sensitivity can be rectified, for example for a homogeneous spatial sensitivity in 2 or 3 directions.

In embodiments of the present invention, the switch is adapted to provide a weighted signal representative of the absolute value of at least one component of the magnetic field wherein at least one of the first or second signal is multiplied by a predetermined factor.

It is an advantage of embodiments that a gain correction can be provided, for correcting different sensitivity of the measurement of magnetic field components in different directions.

In embodiments of the present invention, the magnetic field sensing system comprises a first sensing element being a first Hall element configured so that the direction of maximum sensitivity is the first direction and at least a second sensing element being a second Hall element configured so that the direction of maximum sensitivity is the second direction.

It is an advantage of embodiments of the present invention that the detector is easily implemented with Hall plates and e.g. IMCs, for example vertical and horizontal Hall plates combined with an IMC.

In embodiments of the present invention, the sensing means are configured for providing three signals representative of respectively three components of the magnetic field in three directions different from each other, wherein the comparing means adapted for comparing the sum of the absolute values of the three signals with a threshold value.

It is an advantage of embodiments of the present invention an omnidirectional magnetic sensor can be obtained allowing detecting magnetic field in any direction. It is a further advantage that the assembly constrains (e.g. chip mounting) can be relaxed.

In embodiments of the present invention, the switch further comprises a further sensing element being a Hall element configured so that the direction of maximum sensitivity is different from the first and the further directions.

In a further aspect, the present invention provides a proximity sensing system comprising a magnet and a magnetic switch of any one of the previous claims for detecting the proximity of the magnet within a predetermined distance range.

It is an advantage of embodiments of the present invention that a proximity sensing system can be provided with a simple and reliable magnetic sensor as a magnetic switch. In some embodiments, the magnetic field of the magnet may be between 0.5 mT to 100 mT.

Particular and preferred aspects of the invention are set out in the accompanying independent and dependent claims. Features from the dependent claims may be combined with features of the independent claims and with features of other dependent claims as appropriate and not merely as explicitly set out in the claims.

These and other aspects of the invention will be apparent from and elucidated with reference to the embodiment(s) described hereinafter.

## Brief description of the drawings

FIG 1 is a block diagram of a magnetic switch in accordance with embodiments of the present invention, in the particular case for a 3D switch.
FIG 2 is a block diagram of a switch wherein the sensing elements are sequential elements and provide signals representative of the absolute values of components of the magnetic field.

FIG 3 is a block diagram of a switch wherein the sensing elements are Hall elements and provide sequentially the signals.

FIG 4 is a block diagram of a magnetic switch similar to the one in FIG 3 illustrating an implementation of analog processing.

FIG 5 illustrates the volume covered by the threshold in accordance with the present invention, which can be represented by an octahedron. The detected field is represented by a vector field. If the vector is inside the volume, the switch provides an output, and if outside, the switch provides a different output.

FIG 6 illustrates a different volume covered by two defined thresholds in accordance with the present invention, which can be represented by a truncated octahedron.

FIG 7 and FIG 8 illustrates two alternative magnetic sensors which combine a horizontal Hall plate with vertical Hall plates.

FIG 9 illustrates a perspective view and a cross section of a magnetic sensor combining sensing elements with a magnetic concentrator.

FIG 10 illustrates the top view of an alternative magnetic sensor combining sensing elements with a magnetic concentrator.

The drawings are only schematic and are non-limiting. In the drawings, the size of some of the elements may be exaggerated and not drawn on scale for illustrative purposes.

Any reference signs in the claims shall not be construed as limiting the scope.

In the different drawings, the same reference signs refer to the same or analogous elements.

**Detailed description of illustrative embodiments**

The present invention will be described with respect to particular embodiments and with reference to certain drawings but the invention is not limited thereto but only by the claims. The dimensions and the relative dimensions do not correspond to actual reductions to practice of the invention.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. The term "comprising" therefore covers the situation where only the stated features are present and the situation where these features and one or more other features are present. Thus, the scope of the expression "a device comprising means A and B" should not be interpreted as being limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

Where in embodiments of the present invention reference is made to "magnetic switch", reference is made to a magnetic field detector which is configured to provide a signal representative either a first state or a second state being different from the first under a certain condition or threshold. In binary, the output of a switch is either a 0 signal or a 1 signal. For an electronic switch, the condition that causes switching from one state to another (or 'switching condition') is the presence of, for example, an electric potential larger than a predetermined threshold. In the case of a magnetic switch, the switching condition is the presence or absence of a magnetic field over a predetermined threshold value, or switching threshold, or simply 'threshold' in the following.

The present invention relates to a magnetic switch, including a magnetic field sensing system for detecting or sensing magnetic fields.

The magnetic field sensing system may detect at least two magnetic field components in different directions. Based on these components, a comparison with a threshold is performed. The output of the comparison determines whether there is a switch or not.

Since the magnetic field is detected as a vector in a plane (2D field), the alignment of the sensing system has less influence on the accuracy of the result. It is possible to calculate the vector magnitude of the field based on the value of the detected field components, e.g. Bx and By. In order to obtain the most accurate results, the vectorial magnitude can be calculated from the square sum of said components, $(Bx)^2+(By)^2$ being representative of the projection in the plane of the magnetic field. Comparing that sum to a threshold value, being the radius of the a circumference in the plane where the components Bx, By are defined, is equivalent to checking whether the vector Bx, By is insider or outside the circle.

This requires complex calculations, which leads to high processing power requirements. The present invention provides a result with slightly reduced resolution for switching, but effective for most sensing applications, e.g. automotive applications, for detecting tampering of other measurement devices such as electrometers, etc.. On the other hand, a simple comparison of each measured component of the field with a threshold provides an estimation which is not viable, or it is less desirable and less accurate in many applications.

A simple and accurate implementation of a magnetic switch can be provided as follows. The implementation includes obtaining the absolute value of each component of the field, and comparing their sum to a threshold value. In the following, any threshold value is defined as a positive value. The sum can be a weighted sum, wherein weight coefficients are applied for equalizing the sensitivity of the measurement in each direction. A switch in accordance with embodiments of the present invention requires a simple implementation and very little processing power, since signal processing requires simple components. The inventors have found that, surprisingly, the deterioration of resolution is negligible for many commercial applications.

Moreover, in the particular implementation of a switch which can detect the magnetic field in any direction, the present invention can be adapted in a straightforward manner. Thus, a 3D magnetic field detector (for e.g. a switch) can be provided with a simple implementation.

In a first aspect, the present invention provides a magnetic switch including a magnetic field sensing system. The switch is configured to provide a predetermined output if a field detected by the field sensing system surpasses a threshold. The magnetic field sensing system is configured to detect the magnetic field in at least two directions and provide the absolute values thereof, and the sum of these values is compared to a threshold. The output of the switch is determined by whether the sum surpasses the threshold or not.

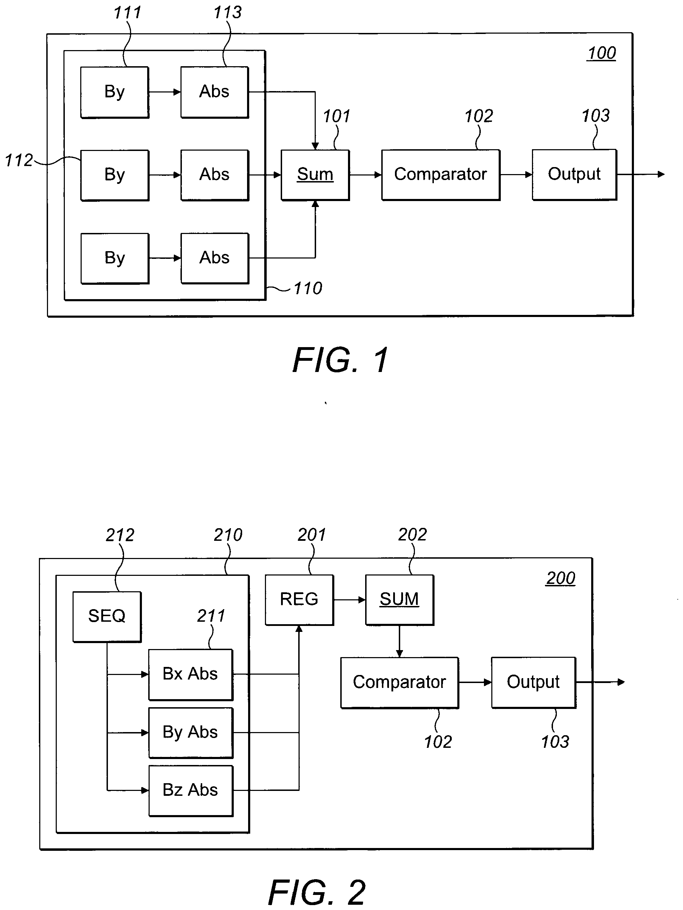

FIG 1 is a block diagram of a magnetic switch in accordance with embodiments of the present invention, in the particular case for a 3D switch.

The magnetic switch 100 includes a sensing system 110. In particular, the sensing system is adapted to provide a first signal as a response to the component of the magnetic field in a first direction. The first signal may be proportional to the absolute value of said component. The system is further adapted to provide a second signal as a response to the component of the magnetic field in a second direction, which may also be proportional to the absolute value of the component in the second direction. The second direction is different from the first direction. In some embodiments of the present invention, the first and second directions are perpendicular to each other (X and Y direction). If only these two are measured, the switch is a 2D switch.

The sensing system may comprise at least one sensing element which generates a signal representative of the value of the component of the field in a first direction. For example, a Hall effect sensing element 111 may be provided. For example, a first and second Hall effect sensing elements 111, 112 may be provided for measuring in the first and second directions (e.g. X and Y directions). The present invention is not limited to Hall effect sensing elements for providing a value of the magnetic field in a first and second directions.

The resulting signal from many sensing elements, including Hall effect sensing elements, include information of the orientation of the field in the given direction. Thus, the absolute value needs to be extracted from the signal.

The absolute value can be obtained with simple computation, for example by digitizing the signal and removing the sign from the digital value. It is possible to provide the absolute value in the analog domain for example by processing the signal using a square function or the like implemented with a suitable unit 113, e.g. implemented with an analog multiplier, a rectifier, optionally including an operation amplifier, or any other circuit adapted to generate an absolute value. Advantageously, any signal offset may be removed from the analog signal, for example in case of signals from Hall elements. This removal of signal offset may be done before processing the signal for providing the absolute value. In some embodiments of the present invention, the absolute value can be obtained using a look-up table.

In some embodiments of the present invention, as shown in FIG 2, the sensing system 210 comprises at least one sensing element 211 configured to provide at least a first signal representative of the absolute value of a first component of the magnetic field in a first direction, and a second signal representative of the absolute value of a second component in a second direction. The signal generated by the sensing element as a response of a component of the field in a first direction is the absolute value of the field, and it does not depend on the direction of the field. No additional processing, software, or hardware is required to obtain the absolute value. In some embodiments, the sensing element 211 or elements may comprise magneto-resistive sensing elements that are intrinsically sensitive to the absolute value of the applied magnetic field. The present invention is not limited thereto, and any other suitable element can be used to provide the absolute value of each component of the field.

The sensing system may comprise two sensing elements for providing readings of the magnetic field in two different directions. For example, only two measurements may be provided, so the switch is sensitive to the field in 2 directions (2D switch). However, the magnetic field sensing system 110, 210 may be configured to provide a third signal representative of the absolute value of a third component of the magnetic field in a third direction, different from the first and from the second direction. In some embodiments of the present invention the third direction is perpendicular to the first direction, for example to the first and second direction (thus, the three directions being X, Y and Z directions).

The sensing system may also provide means for correction of the sensitivity if different sensing elements with different sensitivities are used. These means apply a weight coefficient to the signals as required. The coefficients may be obtained by e.g. calibration. It can be done by analog means (including integrators, amplifiers, etc.), by digital means, etc.

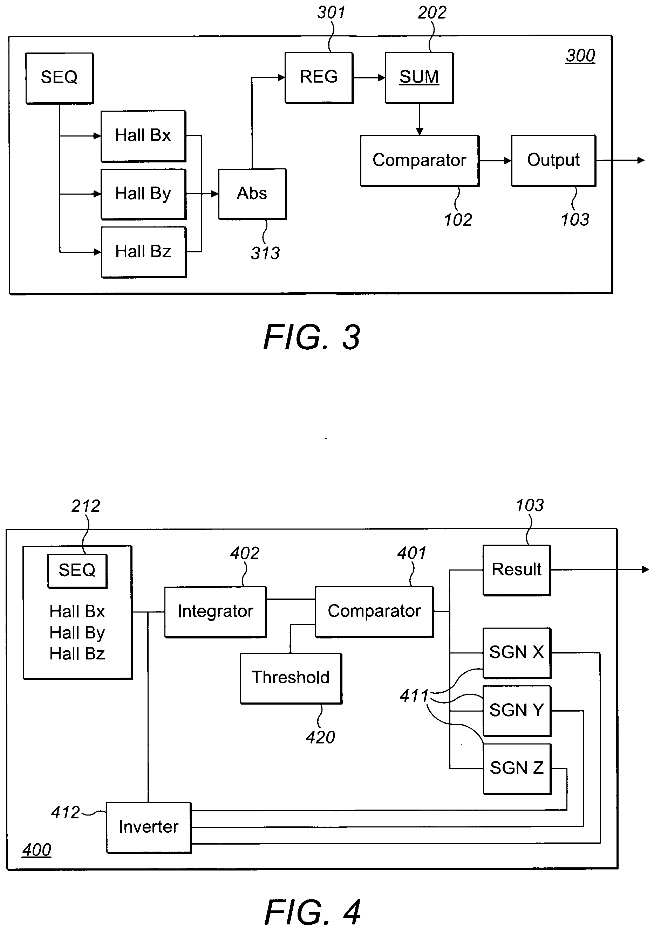

The magnetic switch 200 may be adapted to perform measurements sequentially. For example, the switch may comprise a sequencer or the like, wherein signals representative of the field in each different direction are obtained in a sequence. The particular implementation may provide an sleep/awake operation sequential operation, for low-power operation. This advantageously saves energy. In some embodiments, the magnetic signals are generated sequentially, by e.g. powering sequentially each sensing element. A particular implementation is shown in FIG 2, wherein a sequencer 212 is used for time multiplexing of the signals in three sensing elements which may be magneto-resistive sensing elements 211; however the sequential implementation may be used with two sensing elements in a 2D switch, and/or in combination with any suitable sensing element, for example Hall elements or the like as shown in the switch 300 in FIG 3, wherein only one separate suitable process unit 313 to provide the absolute value is necessary.

Using time multiplexing allows an implementation using only one common channel, thus simplifying the circuitry. Each signal may be temporarily stored in a storage unit 201, 301, e.g. a register in the switch 200, 300. For example, the signals can be transmitted through a single channel and the absolute value calculated. The storage unit 201, 301 temporarily stores the absolute values as required. This allows adding up the value of the field measured for one or more different directions, e.g. absolute values obtained sequentially. Since a single channel is required for transmitting all the signals, the set up can be simplified over a setup with a channel connected to, for example, each sensing element, needing several units to provide the absolute value and e.g. several input contacts for obtaining the sum.

The sequencer can be configured to obtain a measurement periodically with a predetermined period of time, e.g. between one microsecond and half second (500 ms), for example between 10 microseconds and 10 ms.

Once the required signals, representative of the absolute values of the magnetic field components, are obtained, said signals are added up. The magnetic switch further comprises means 101, 202, to provide the sum of said absolute values, as explained further below. The result is compared to a predetermined threshold value. The threshold value may depend of the status of the switch (e.g. the value of the output of the switch). A comparing means 102 can be used, e.g. an analog comparator, e.g. comprising an operational amplifier configured as a comparator, if the sum of the absolute values is represented by an analogic signal, or digital comparator if the absolute value is represented as a digital signal. The comparator may store a plurality of different thresholds which can be chosen for comparison (e.g. depending on the value of the switch). The comparator is adapted to provide one of two values as output 103, either a high or low signal, which are interpreted in binary as zero and one.

In the following, summing means are discussed. The summation of the signals may be done in the digital domain. The signals may be digitized (e.g. before or while providing the absolute values if such step is required, e.g. with the suitable processing unit 113, 313), and the bit corresponding to the sign may be dropped. Where the absolute values are represented by digital signals, the sum can be easily done by well-known processing means. Where the absolute values are analogue signals, the signals can be processed to digital signals using any known means, such as an Analog to Digital converter (ADC) or the like, and then they can be summed in the digital domain.

The present invention allows analog processing as well, including the determination of the absolute value and/or for the sum and comparison with a threshold. For example, in some embodiments, the sign of each value may be extracted by analog means. Then, the values may be added up, switching the sign if necessary using the information obtained from the sign extraction. The sum of the absolute values is then compared to the relevant threshold value.

An exemplary embodiment of analog processing is shown in the switch 400 of FIG 4 . The sign of the field components (e.g. Bx, By, Bz in 3D) can be determined with a comparator 401. The threshold setting means 420 of the comparator (or connected to the comparator 401) is set to 0, and the signal representing a component (e.g. Bx) of the field is processed by the comparator, to obtain the sign of each magnetic field component. The information is memorized, for example using a first flip flop 411 which may be part of the comparator 401 or may be an external unit

The means to provide the sum comprises an integrator 402 to add the components one by one (e.g. Bx, By and Bz), using inverters 412 to switch signs suitably in order to obtain, at the end, the sum |Bx|+|By|+|Bz|, in case the of a 3D switch. In the 2D case, the process is similar, only using two sensing elements and two flip flops 411.

More in detail:

The process of integration can take place in several subcycles, at least one subcycle per component (e.g. subcycles for Bx, By, Bz). In the first cycle:
The magnetic field sensing system provides a signal for each component, one at a time, for example first a voltage relating to Bx. The signals are sent through an integrator 402 for a set time. Typically the signal is a voltage, so integration reduces noise and does not change the sign of the outcome. Once the signal corresponding to Bx is integrated, it is sent to the comparator 401 wherein threshold setting means 420 set the threshold to 0. At this point, the signal in the integrator can be removed and the next component can be read, so for example a voltage relating to e.g. By is being integrated. It is possible to set a clock in the circuit to sequence and tell apart which signals are related to which component Bx, By, Bz.

Since the comparator is set to 0, the outcome of the comparator is a binary value representing whether the component is positive or negative. The outcomes of the comparator are stored in the flip flop circuit SGNX.

The same is done for the rest of components:

after integration of By, the comparator extracts the sign which is stored in the corresponding flip flop circuit SNGY, then the signal corresponding to By is removed and the process is repeated for any further component (e.g. Bz) if needed. The flip flop circuits may also have clocks so a correspondence between the sign and its component is established. Since Bx, By, Bz are obtained sequentially, each flip flop is filled one at a time.

The signals stored in the flip flop circuits are sent back to an inverter 412 for a second cycle. In this second cycle, the signal corresponding to Bx is obtained again. Then upon integration of Bx, the inverter uses the stored value of SGNX to tell the integrator to integrate with a minus or plus sign, so the absolute value is obtained. Of course, it is supposed that this process occurs faster than any sign change in the component Bx of the magnetic field being detected. The switch may be configured to run further integration cycles. The number of cycles, also compared to the number of cycles for other components, allows already providing a weight coefficient. For example if for Bx the number of cycles run equals twice the amount for the other components, to get 2*abs(Bx). Thus, the present implementation allows providing weight coefficients as gain coefficients. The present invention is not limited to this, and different means for implementing weight coefficients could be used. For example, an amplifier may be introduced in front of the integrator 402.

Once the integration of the signal corresponding to the first component Bx is completed with the appropriate sign to make the sign representative of the absolute value, then the signal corresponding to By starts being collected (using the corresponding sign stored in the appropriate flip flop SGNY). However, during the second cycle, the integrator is not reset as before during the first cycle. This means that the previous integrated absolute value (abs(Bx)) stays and the following signal abs(By) is added to it. When the integration is completed, the same is done for a further component Bz if needed. As before, gain coefficients can be added by providing different numbers of integration cycles.

At the end the integrator 402 has a signal corresponding to abs(Bx)+abs(By)+abs(Bz)

Then, the threshold switching means 420 for the comparator is set to provide a non-zero threshold value, e.g. the relevant operating point threshold for comparing the sum of the absolute values with the appropriate threshold. The result of the comparison determines the output 103 of the switch as before.

The same comparator 401 is advantageously used for both extracting the signs before processing the signals to obtain the sum of the absolute values, and for doing the threshold comparison with an operating point threshold. Thus, the comparator 401 (with the threshold 420 set at zero) can be considered as part of the magnetic field sensing system which provide the sum of the absolute values of the components of the field.

Any other known means for obtaining the sum of the values representative of the component of the magnetic field in each direction can be used. In those embodiments where two signals are obtained, these signals are summed. For example, the signals may represent the absolute value of the field in the X and Y components:

$$S_{2D} = |Bx| + |By|$$

In those embodiments where three signals are obtained, the three signals are summed. For example, the signals may represent the absolute value of the field in the X, Y and Z components:

$$S_{3D} = |Bx| + |By| + |Bz|$$

The obtained sum is then compared to at least one threshold. In the following, the details of the comparison are laid out and discussed relative to known methods.

The comparison using the sum of the absolute values is an approximate solution. The alternative of providing the actual magnetic field requires a higher processing power. For example, considering two perpendicular coordinates X, Y, the high precision route requires measuring the field components Bx, By and obtaining the magnitude of the field:

$$B = (B^2x + B^2y)^{1/2}$$

The outcome of comparing the magnitude B to a threshold value gives information whether the vector representative of the magnetic field is inside or outside the area of a circle. In the case of a 3D switch, the calculation of the magnitude (including sum of squares) would be analogous but in the 3D, and the outcome gives information whether the vector is inside or outside a sphere with a radius equal to the threshold, therefore providing switching or not.

On the other hand, instead of calculating the magnitude of the vector (in 2D), it is possible to check whether the vector is inside or outside of the circle, by comparing every pair of coordinates with pairs of coordinates that follow the function of the perimeter of a circumference where the radius is the threshold. This requires a large number of pairs of values to be stored on e.g. a memory, and the comparison also requires processing power. For the 3D case, with an additional coordinate, the memory requirements increase. A different approach is performing a rough approximation and comparing each measured value Bx and By (and Bz in case of a 3D case) with a threshold value. This is the equivalent of studying whether the vector is inside or outside a square (or a box, in the 3D case). The present invention, on the other hand, allows reducing processing power, since there is no need to perform at least the square function calculation.

The area covered by the threshold in the case of calculating the magnitude B can be represented as a circle in the case of 2D, or a by a sphere in case of 3D.

However, the present invention allows a simpler representation. In the 2D domain, the comparison can be represented by the following function:

$$|Bx| + |By| - Bop = 0,$$

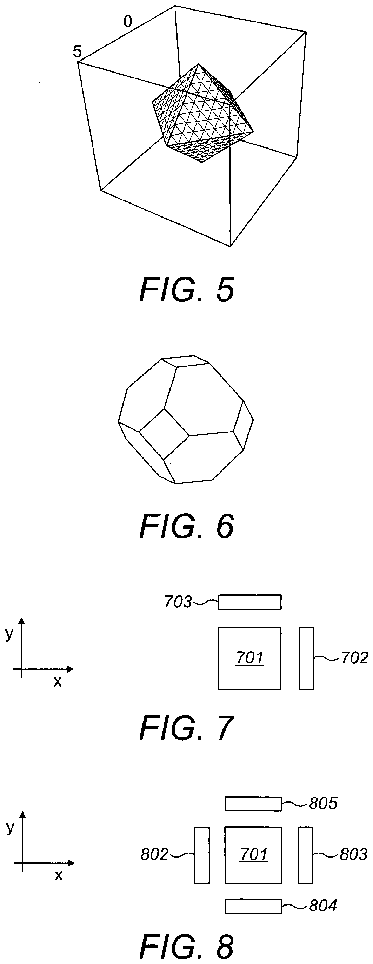

where Bop is an absolute threshold value. Since the switching occurs when function |Bx|+|By|-Bop changes sign, the threshold receives the name of operational threshold field (hence, Bop). This can be represented in the 2D by a square where the vertices lie on the axes. In the 3D domain, the volume covered by the threshold can be represented by an octahedron as shown in FIG 5 in case of the present invention.

In 3D, the volume covered by the threshold gives a good estimation of how accurate an approximation is. The calculation allowing treating the threshold as a sphere results in the following volume, where its radius is 'a':

$$Vsphere = \pi * a^3 / 6 = 0.52 * a^3$$

On the other hand, the rough estimation of comparing each measurement with the threshold value results in a volume of:

$$Vcube = a^3$$

The volume of the octahedron is closer to the volume of a sphere:

$$Vohedron = 2^{1/2} * a^3 / 3 = 0.47 * a^3$$

Clearly, the volume of an octahedron is a good approximation to the volume of a sphere, but processing of the signals representative of each component is simpler for the case of the octahedron than the calculation of the magnitude of the vector, and also does not require an extensive use of memory. It is, however, a more accurate representation than simply comparing the result to a threshold, which is equivalent to studying whether the vector is within the volume of a cube or not.

It is noted that more than one threshold can be defined, analogously to switches in electronics, to avoid oscillating switching due to e.g. noise. The switch is configured to provide either a first or a second output value (being different from each other, for example 0 and 1). One of the values is provided if the sum is higher than a threshold value (for example an operational threshold value Bop). The second output value is provided if the sum is lower than a second threshold value. However, the switching from a first output to a second output may be done at a different threshold than the switching from the second to the first output.

The switch may be configured so that the switching from the first to the second output value (e.g. the switch from 0 to 1) occurs when the sum surpasses a first threshold value (Bop). The switch may also be configured so that the switching from the second to the first (e.g. from 1 to 0) when the sum drops below a second threshold value, also called release threshold field (Brp) or simply release threshold. The release threshold is usually lower than the operational threshold (thus, Brp < Bop) to avoid output oscillation in case of noise in the measured signals. The difference between the operational and release threshold, also known as hysteresis, is highly flexible. It can be 2.5% up to 80%. For example, the switch may be configured so that the switching from 1 to 0 can occur at a magnetic field with half value as the switching from 0 to 1. This can translate to a difference between the operational and the release threshold between 0 to 3 mT.

In some embodiments, as already pointed out, different sensing elements can be used, e.g. at least one sensing element for sensing the field in each required direction. Although the sensing elements should be equivalent to each other, in practice the sensitivity of each element may vary. The present invention allows gain correction of the signal. For example, the magnetic switch may be adapted to provide at least one weighted signal representative of the absolute value of a respective component of the magnetic field of one direction. The weight may be implemented as a predetermined multiplicative factor. Any suitable way of applying the multiplication factor (e.g. gain) can be used, in the digital or analog domain as the specific case requires. The factor or factors can be obtained by calibration, simulation, etc. Thus, the general expression for the sum in three dimensions is:

$$S_{3D} = Gx^* |Bx| + Gy^* |By| + Gz^* |Bz|$$

The weight factors Gx, Gy, Gz may be different as needed. For example, only one factor may be used, so the other two may be 1. Alternatively, one of them may be 1, and the other two may be different than 1, and even different from each other. Alternatively, each weight factor may be different from 1 and/or different from each other. A maximum of one weight factor may be needed for each measured component. For example, in the 2D case, only two weight factors are required. The graphical representation of the influence of the weight factors is, in the 2D domain, a shortening or elongation of one of the axis in both the positive and negative direction, (since the absolute values are used). In 3D domain, the octahedron becomes elongated on some sides. This not only allows manipulating the volume so make it closer to the sphere, but also the shape, if required, so it approximates to the sphere shape even further.

The switch behaviour could be further manipulated, e.g. improved, by using an additional threshold, different from Bop, which in some embodiments is the 'release threshold field' Brp. The magnetic switch may be configured to switch the output 103 from a first value to a second value being different from the first if the sum of the absolute of the signals is above the operational threshold Bop. Further, the magnetic switch may be configured to switch the output from the second to the first value if the sum of the absolute of the signals does not surpass a release threshold Brp. Thus, the switch is adapted to compare the sum with the two thresholds. In this case, if the output of the switch in a given state is a first output, and then the state changes by changing the magnetic field, so the sum surpasses the first threshold Bop, the output switches to the second output. If the output is the second output, the switch may be adapted to switch to the first output if and when the sum drops below the release threshold Brp. The second threshold Brp has a value strictly different than the first threshold Bop, thus the switching is performed, in principle, at different magnetic fields, depending on whether the switching is from a first to a second value or vice-versa as explained above. Preferably, Brp is a lower threshold than Bop. This avoids oscillating signals, so the output of the switch is advantageously stable. In some embodiments, Brp is approximately half of Bop. For example, one threshold may correspond to a voltage generated by the sensing elements, e.g. Hall sensing elements, which is around the order of 100 mV. So for example, taking into account that Brp is about half of Bop, if Brp corresponds to a threshold of 100 mV, then Bop corresponds to 200 mV. The magnetic field may be between 0.5 mT ot 100 mT.

The second threshold Brp defines a second octahedron centered relative to, and inside of, the octahedron shown in FIG 5. The volume of the second octahedron is smaller since the second threshold is lower than the first.

Additional thresholds can be defined. These thresholds allow more freedom in manipulating the sensitivity. A second operational threshold Bop2 value can be defined, which is higher than the release threshold but lower than the first operational threshold. The second threshold Bop2 is only used if the sum does not surpass the first operational threshold Bop1. If the switch is in a state such that its output is the first output (e.g. 0), and the sum does not surpass the first operational threshold Bop1, the absolute value of the magnetic field component in each direction (not the sum thereof) is compared to the second threshold Bop2. Thus, in case of the 3D domain, each of the values |Bx|, |By|, |Bz| (or the weighted values) are used for the comparison. In case of the 3D domain, the volume covered by the thresholds is shaped as a truncated octahedron such as the one in FIG 6. If any one of the values surpasses the second threshold Bop2, the switch is configured to switch to the second value (e.g. from 0 to 1). Since the ideal switching behavior results in a threshold volume covering a sphere (in the 3D domain), and the truncated octahedron is closer to the sphere, then the switch in accordance with embodiments of the present invention has a behavior close to the ideal behavior, without need of performing complex calculations.

Analogously, the release threshold in accordance with embodiments of the present invention may be first release threshold Brp1 and a second release threshold field Brp2 can be defined. The second release threshold is higher than the first threshold. However, it is lower than the operational threshold, or than any operational threshold (e.g. first or second, thus Brp2<Bop2, and/or Brp2<Bop). When the switch status is set to the second value (e.g. 1), the sum of the absolute values of the components of the field in different directions is compared to the first release threshold Brp1 as explained earlier. If it does not surpass the first release threshold, in case of the 3D domain, each of the values (e.g. |Bx|, |By|, |Bz|, or the weighted values) are compared to the second release threshold Brp2. If any of the absolute values drop below the second release threshold, the switch is configured to change the output to the first value (e.g. 0). So, for both switchings (from 0 to 1 and for 1 to 0), the behaviour can be approximated to the ideal behaviour of a sphere, by providing a behaviour of a truncated octahedron (in the 3D space) as shown in FIG 6.

Thus, in some embodiments, four thresholds can be defined: a first and second thresholds corresponding to e.g. operational and release threshold values, and third and fourth thresholds corresponding to e.g. a second operational and second release threshold values.

Alternatively, the switch may be adapted to compare the highest of two signals, one signal being representative of the absolute value of the field component in one direction (or the weighted signal), and the other being representative of the sum of the absolute value of the field components in two other directions different from the first. While the switch is adapted to provide these sums, the output is dependent of an additional condition, namely the maximum value between two signals. Taking into account perpendicular components X, Y, Z and the weights for sensitivity correction, the present invention not being limited thereto, the comparison may be such that:

$$Bth < Max\left(Gz*|Bz|, \, sum(Gx*|Bx|+Gy*|By|)\right)$$

Other combination of components may be used, not necessarily only comparing the component in Z with the sum of the X and Y components. It is possible to use different functions, Bx, By, By and terms to put inside this maximum function.

Instead of an octahedron, the space would be a rotated cube with a length of twice the relevant threshold.

Thus, the switch is adapted to provide a sum of signals representative of the absolute value of at least two field components detected by sensing elements. In any case, the switch is also adapted to compare the result of the sum with a threshold. The comparison can be made relative to a threshold which is chosen depending on the output status of the switch, optionally also depending on the result of the comparison with the sum. Alternative the comparison can be made using three signals, the first signal |Bz| representative of the absolute value of a component in a direction, the second signal |Bx|+|By| depending on the sum of absolute values of two components in different directions. A first comparison is made between the first and second signals, and the greater of the two is compared with a threshold chosen as before.

It is noted that the absolute values, and/or the sum thereof, can also be implemented by applying the signals generated by the sensing elements in a processor to a look-up table. The lookup table would include values which form an octahedron for a 3D switch (or a projection thereof in 2D), so it is also possible to check whether the obtained signal are within or outside the octahedron.

The magnetic switch is adapted to provide an output 103, based on the result of the comparing means 102, 401 e.g. a comparator. The output of the switch is binary, meaning that it can take one of two values. If the detected field surpasses a threshold, the output 103 is a has a first value (e.g. 1). If the detected field does not surpass a threshold, the output has a second value (e.g. 0). As seen before, the comparison may take into account the current value to select one among several thresholds, including e.g. an operational and release thresholds, optionally a third and fourth thresholds (Bop2 and/or Brp2), it may even take into account the largest of two signals to choose which signal is compared to the threshold. In any case, a signal is obtained from summing the absolute values of the field in at least two different directions, as obtained by sensing the field.

It is noted that the magnetic sensing system may comprise a magnetic sensor including sensing elements which are adapted to provide the required signals, e.g. two or three signals representative of the field components in two respectively three different directions. This can be provided in a single chip, as mentioned earlier. Some examples of magnetic sensors are discussed with reference to FIG 7 to FIG 10, as follows.

In embodiments wherein the sensing elements are Hall elements, horizontal and vertical Hall plates may be provided in combination, optionally including one or more magnetic concentrators (e.g. integrated magnetic concentrator IMC). The Hall plates and optionally MCs may be combined to provide the required signals representative of the field components in the required directions, for example two or three different directions.

FIG 7 shows a horizontal Hall plate 701 combined with two vertical Hall plates 702, 703 which can be used as part of the magnetic field sensing system in accordance with some embodiments of the present invention. They may be configured so that the signal provided by them represents the magnetic field 3 different directions, e.g. three perpendicular directions. For example, the vertical plates 702, 703 are sensitive to the field in X, Y directions and the horizontal plate 701 is sensitive to the vertical component Z of the field.

FIG 8 shows an alternative embodiment wherein two vertical plates 802, 803 are sensitive to one horizontal component X and two other vertical plates 804, 805 are sensitive to a horizontal component Y in different direction, e.g. perpendicular, to the previous component X. These can be used to obtain different combinations of the signals from the field if required, for example to reduce external influences such as noise and the like.

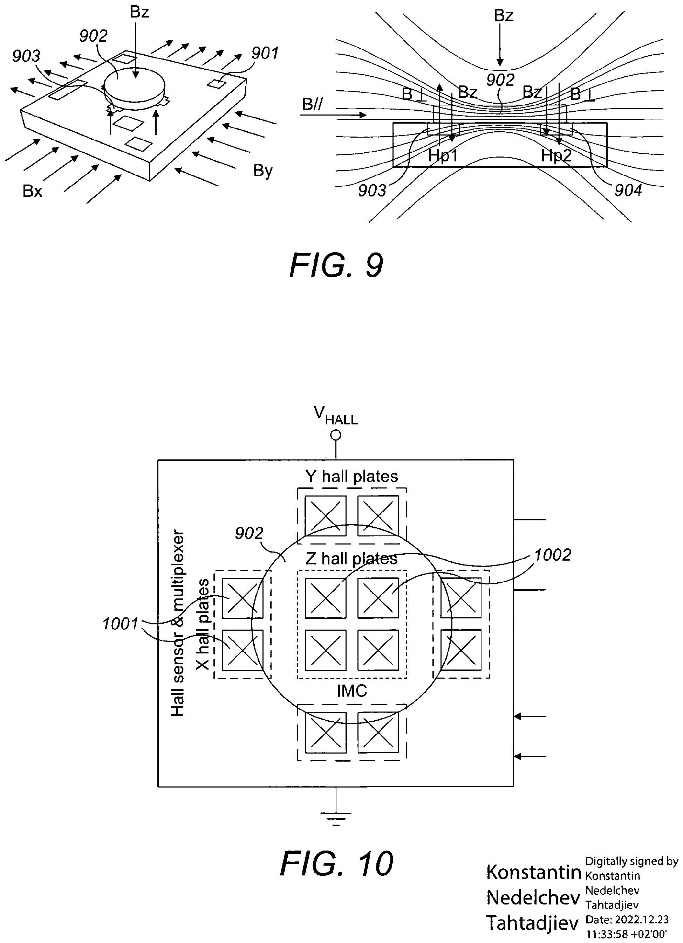

In some embodiments of the present invention, magnetic concentrators MC can be used, e.g. an integrated MC, in combination with Hall plates. FIG 9 shows a perspective view on the left, and a cross section on the right, of a sensing system with one or more Hall plates 901 distributed through the surface, to obtain differential fields for example. There is a central IMC 902 surrounded by two pairs of horizontal Hall plates 903, 904 on opposite sides of the IMC. The IMC provides redirectioning of the field lines, so the horizontal component of the field (e.g. Bx) can be redirected as a combination of a parallel component B// and perpendicular component B⊥. The perpendicular components are detectable by the horizontal Hall plates 903, 904. In particular, the perpendicular component on one side of the IMC 902 extends in a direction (upwards) which is detectable by the first horizontal Hall plate 903 and in an opposite perpendicular direction (downwards) when crossing the second horizontal Hall plate 904 of the pair, on the other side of the IMC 902. On the other hand, the contribution of the perpendicular component Z of the field has the same direction in both Hall plates of the pair. Thus, it is possible to obtain the horizontal and vertical components by signal processing (e.g. subtracting both signals allows calculating the horizontal component Bx from the upwards and downwards component B1, and adding both signals allows calculating the vertical component Bz).

Thus, it is shown that two sensing elements may provide two signals representative of the field in two directions, either by providing one signal per sensing element as in FIG 7, a gradient or difference thereof (as in FIG 8), or by an appropriate combination of the signals provided by each sensing element, as seen in FIG 9.

FIG 10 shows, as a top view, an alternative embodiment of a sensing system, which is advantageously compact. As before, the IMC 902 may be surrounded by horizontal Hall plates being the sensing elements 1001 for obtaining the components of the field in two different directions X, Y as explained before. It may include additional horizontal Hall plates being additional sensing element 1002 underneath the IMC, thus allowing saving space. For example, two pairs of Hall plates may be provided on each side of the IMC, to obtain the components Bx, By, and further four horizontal Hall plates 1002 can be placed underneath the IMC to obtain the vertical component Bz.

In some embodiments, the magnetic sensing system 110, 210 may be implemented as an integral unit, e.g. monolithically implemented in a semiconductor die, comprising e.g. IMCs, sensing elements including e.g. Hall plates, electronic circuitry for powering the elements, signal routing systems, and the like. In some embodiments, the magnetic sensing system may also comprise units such as comparators for providing the absolute value, which may be used also for other applications (such as comparing with a switching threshold).

In an aspect, the present invention provides a position sensing system comprising a magnet and a magnetic switch in accordance with embodiments of the previous aspect. The magnetic switch may detect the position of a magnet when the detected field surpasses or not a predetermined field, wherein the magnetic field generated by the magnet is known. The magnetic field generated by the magnet may be 0.5 mT to 100 mT. For example, the position sensing system may be proximity sensor which senses the presence or absence of the magnet, when the field surpasses or not the threshold.

The magnet may be a dipole, a quadrupole, etc. The choice of the type of magnet for the activation of the switch is done taking into account the particular application of the switch, in particular thermal considerations, which may affect the magnet.

A position sensing system or proximity sensing system in accordance with embodiments of the present invention provides a signal when the field is detected. The detection is provided irrespective of the orientation of the magnet in the plane, if the system comprises a 2D magnetic switch, or in the space if the system comprises a 3D magnetic switch, in accordance with embodiments of the present invention.

In another aspect, the present invention provides a method of switching between two states, under the presence or absence of a magnetic field of a predetermined value.

The method can be carried out by a magnetic switch of the first aspect of the present invention. The method can be used as a method of sensing proximity of a magnetic target, e.g. a magnet, as described with reference to the second aspect of the present invention.

The method comprises providing a first reading of a magnetic field component in a predetermined direction. The method comprises providing the sum of at least two signals, including a first signal representative of the absolute value of the field in a known direction and at least a second signal representative of the absolute value of the field in a different direction.

For example, in some embodiments, sensing elements can be used which directly provide the absolute value of the field component (such as some MR elements). In such cases, the signals may be simply added up.

For example, in some embodiments, directional sensing elements may be used, which include information of the orientation of the field. Such is the case of e.g. Hall plates. In this case, the method comprises providing a first reading of the field component, in one direction, and at least a second reading of a magnetic field component in a different direction. Subsequently, the absolute value of the signals is obtained from each reading. This may be done in analog or digital domain.

In some embodiments, at least one of absolute values may include a multiplicative weight coefficient for correcting the sensitivity of each sensing element, so the sensitivity is substantially the same in every direction.

Subsequently, the sum of the absolute values is provided. The sum is subsequently used is a comparison process with a switching condition, the outcome being one of two outputs available to the switch.

The comparison process may comprise comparing the sum of the absolute values corresponding to two different directions with the absolute value in a third direction. The highest of both (Maximum function) is compared to a switching threshold. If the highest value complies with the condition of switching, the output is switched.

Alternatively, the comparison process may comprise comparing the sum directly to a switching threshold. If the sum complies with it, the output is switched. Such switching shows a good accuracy for most application, and it requires simple circuitry and light processing.

The method may comprise providing a switching condition including establishing the current output of the switch, and using a first threshold (e.g. an operative field threshold) for a first output to determine the switching to the second output, wherein the switching condition is surpassing (respectively falling under) the threshold; or using a different threshold (e.g. a release threshold) if the current output is the second output, wherein the switching condition is falling under (respectively surpassing) the threshold. Thus, the switching conditions may be different and are chosen in accordance with the current status of the switch. Such switching is stable. The release threshold can be lower than the operational threshold, avoiding oscillation.

If the main switching condition is not complied with, the method may comprise comparing each (optionally weighted) absolute value for each direction with another threshold. The threshold is chosen to be lower (respectively higher) than the threshold not surpassed (respectively fell under). These additional thresholds may be a second operational threshold $Bop2$ being lower than the operational threshold $Bop1$ being the main switching condition, optionally higher than any release threshold, and/or a second release threshold $Brp2$ being higher than the release threshold $Brp1$ being the main switching condition. This option allows providing a switching with higher accuracy, since the components of the field can be approximated further to the behaviour of the module of the magnetic field vector.

In an alternative embodiment, the method may comprise obtaining the absolute value (if required) by applying the signals from the sensing element to a look up table. In some embodiments, even the sum can be provided by use of a look up table, and comparing whether the sum is inside or outside an octahedron.

## Claims

1. A magnetic switch (100, 200, 300, 400) comprising a magnetic field sensing system (110, 210) configured for providing a first signal representative of the absolute value of a first component of the magnetic field in a first direction and at least a second signal representative of the absolute value of a second component of the magnetic field in a further direction different from the first direction, further comprising comparing means (102, 401) adapted for comparing the sum of the absolute values of at least the first and second signals with a threshold value, the magnetic sensor further comprising a connection to the comparing means for providing at least one status signal as output of the switch.

2. The switch of the previous claim wherein the sensing system comprises signal processing means (113, 313, 401, 411, 420, 412) for providing the absolute value of at least the first and second signals.

3. The switch of any one of the previous claims wherein the at least first direction and second direction are perpendicular to each other.

4. The switch of any one of the previous claims further comprising an analog-to-digital converter for converting the analog signals in digital signals.

5. The switch of any one of the previous claims wherein the comparing means comprises a look-up table.

6. The switch of any one of the previous claims wherein the switch is adapted for providing the first and at least the second signals sequentially.

7. The switch of any one of the previous claims wherein the magnetic field sensing system comprises at least one sensing element (701, 802, 803, 901, 902, 904, 1001) adapted to provide the first signal and at least a further (702, 703, 804, 805, 903, 904, 1002) element adapted to provide the at least second signal.

8. The switch of any one of previous claims wherein the switch is configured to provide one of a first or a second output value different from the first, wherein the first output value is provided if the sum is higher than a threshold value being a first threshold value, and wherein the second output value is provided if the sum is lower than a second threshold value, and wherein the switch is configured to switch from the first output value to the second output value, so that the switching from the first to the second output value occurs when the sum switches from being higher than the second threshold value to being lower, and the switching from the second to the first output value occurs when the sum switches from being lower than the first threshold value to being higher, wherein the second threshold value is lower than the first threshold value.

9. The switch of any one of the previous claims being configured to perform a further comparison if the switch provides a first output value and the sum is not below the threshold value, or if the switch provides a second output value and the sum is not over the threshold value, wherein the further comparison comprises comparing any of the absolute values of the at least first and signals with an additional threshold value above, respectively below, the threshold value, the switch being configured to subsequently switch the output value if any of the absolute values of the at least first and second signals sinks below, respectively surpasses, the additional threshold value.

10. The switch of claim 8 being further configured to perform a further comparison if the sum is higher than the second threshold value but lower than the first release threshold value, wherein the second comparison comprises comparing each signal representative of the absolute value of each component to a third threshold value and/or a fourth threshold value, wherein the first output value is provided if any of the signals is higher than the third threshold value, so that the switching from the second to the first output value occurs when any of the signals surpasses the third threshold value, and/or wherein the second output value is provided if any of the signals is lower than the fourth threshold value, so that the switching from the first to the second output value occurs when any of the signals sinks below the fourth threshold value.

11. The switch of any one of the previous claims further adapted to provide a weighted signal representative of the absolute value of at least one component of the magnetic field wherein at least one of the first or second signal is multiplied by a predetermined factor.

12. The switch of any one of the previous claims wherein the magnetic field sensing system comprises a first sensing element being a first Hall element (111) configured so that the direction of maximum sensitivity is the first direction and at least a second sensing element being a second Hall element (112) configured so that the direction of maximum sensitivity is the second direction.

13. The switch of any one of the previous claims wherein the sensing means are configured for providing three signals representative of respectively three components of the magnetic field in three directions different from each other, wherein the comparing means adapted for comparing the sum of the absolute values of the three signals with a threshold value.

14. The switch of the previous claim further comprising a further sensing element being a Hall element configured so that the direction of maximum sensitivity is different from the first and the further directions.

15. A proximity sensing system comprising a magnet and a magnetic switch of any one of the previous claims for detecting the proximity of the magnet within a predetermined distance range.

FIG. 1

FIG. 2

FIG. 3

FIG. 4

FIG. 5

FIG. 6

FIG. 7

FIG. 8

**FIG. 9**

**FIG. 10**

**EUROPEAN SEARCH REPORT**

Application Number

EP 22 47 2006

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 9 618 318 B2 (TYCO ELECTRONICS AMP GMBH [DE]; TD CONNECTIVITY GERMANY GMBH [DE]) 11 April 2017 (2017-04-11) | 1-5,7,8, 11-15 | INV. H03K17/97 |
| A | * column 3, line 6; figure 1 * <br> * column 7, line 14 – line 16 * <br> ----- | 6,9,10 | |
| Y | US 2021/199730 A1 (CLOSE GAEL [CH] ET AL) 1 July 2021 (2021-07-01) | 1-5,7,8, 11-15 | |
| A | * paragraph [0162] * <br> ----- | 6,9,10 | |
| A | US 9 678 577 B1 (RUTLEDGE AUSTIN S [US] ET AL) 13 June 2017 (2017-06-13) <br> * figures 10,11,12 * <br> ----- | 1-15 | |
| A | US 2018/172423 A1 (AUSSERLECHNER UDO [AT]) 21 June 2018 (2018-06-21) <br> * paragraph [0103] – paragraph [0105] * <br> ----- | 1-15 | |

**TECHNICAL FIELDS SEARCHED (IPC)**

H03K
G01D

The present search report has been drawn up for all claims

| Place of search | Date of completion of the search | Examiner |
|---|---|---|
| The Hague | 18 May 2023 | Fermentel, Thomas |

EPO FORM 1503 03.82 (P04C01)

## ANNEX TO THE EUROPEAN SEARCH REPORT
## ON EUROPEAN PATENT APPLICATION NO.

EP 22 47 2006

This annex lists the patent family members relating to the patent documents cited in the above-mentioned European search report.
The members are as contained in the European Patent Office EDP file on
The European Patent Office is in no way liable for these particulars which are merely given for the purpose of information.

18-05-2023

| Patent document cited in search report | | Publication date | Patent family member(s) | | Publication date |
|---|---|---|---|---|---|
| US 9618318 | B2 | 11-04-2017 | CN | 104204730 A | 10-12-2014 |
| | | | DE | 102012203225 A1 | 05-09-2013 |
| | | | EP | 2820384 A1 | 07-01-2015 |
| | | | JP | 6113197 B2 | 12-04-2017 |
| | | | JP | 2015512040 A | 23-04-2015 |
| | | | US | 2015046117 A1 | 12-02-2015 |
| | | | WO | 2013127984 A1 | 06-09-2013 |
| US 2021199730 | A1 | 01-07-2021 | CN | 113124741 A | 16-07-2021 |
| | | | EP | 3845864 A1 | 07-07-2021 |
| | | | US | 2021199730 A1 | 01-07-2021 |
| US 9678577 | B1 | 13-06-2017 | US | 9678577 B1 | 13-06-2017 |
| | | | US | 10466803 B1 | 05-11-2019 |
| US 2018172423 | A1 | 21-06-2018 | DE | 102016124952 A1 | 21-06-2018 |
| | | | US | 2018172423 A1 | 21-06-2018 |

EPO FORM P0459

For more details about this annex : see Official Journal of the European Patent Office, No. 12/82